(19) Europäisches Patentamt
European Patent Office
Office européen des brevets

(11) **EP 3 067 653 A1**

(12) **EUROPEAN PATENT APPLICATION**
published in accordance with Art. 153(4) EPC

(43) Date of publication:
**14.09.2016 Bulletin 2016/37**

(51) Int Cl.:
*F28F 1/40* (2006.01)    *B21D 53/04* (2006.01)
*B32B 1/08* (2006.01)    *B32B 5/18* (2006.01)
*B32B 15/01* (2006.01)    *F28D 7/10* (2006.01)
*F28D 7/16* (2006.01)    *F28F 21/08* (2006.01)

(21) Application number: **14861006.6**

(22) Date of filing: **01.08.2014**

(86) International application number:
**PCT/JP2014/070308**

(87) International publication number:
**WO 2015/068437 (14.05.2015 Gazette 2015/19)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **06.11.2013 JP 2013230094**

(71) Applicant: **Sumitomo Electric Industries, Ltd.**
**Osaka-shi, Osaka 541-0041 (JP)**

(72) Inventors:
• **SAKAIDA, Hideaki**
**Osaka-shi**
**Osaka 554-0024 (JP)**
• **HOSOE, Akihisa**
**Osaka-shi**
**Osaka 554-0024 (JP)**

• **NISHIMURA, Junichi**
**Osaka-shi**
**Osaka 554-0024 (JP)**
• **OKUNO, Kazuki**
**Osaka-shi**
**Osaka 554-0024 (JP)**
• **KIMURA, Koutarou**
**Osaka-shi**
**Osaka 554-0024 (JP)**
• **GOTO, Kengo**
**Osaka-shi**
**Osaka 554-0024 (JP)**
• **MOTOMURA, Junichi**
**Osaka-shi**
**Osaka 554-0024 (JP)**

(74) Representative: **Boult Wade Tennant**
**Verulam Gardens**
**70 Gray's Inn Road**
**London WC1X 8BT (GB)**

(54) **METAL TUBE, HEAT TRANSFER TUBE, HEAT EXCHANGE DEVICE, AND METHOD FOR MANUFACTURING METAL TUBE**

(57)    A metal tube including a metal substrate and a metal porous body disposed on at least part of a surface of the metal substrate. The metal tube is obtained by the steps of: joining the metal porous body to at least part of the surface of the metal substrate in flat plate form; and forming the metal substrate with the metal porous body joined thereto into a tubular shape.

FIG. 1

**Description**

Technical Field

The present invention relates to a metal tube having a three-dimensional network structure, to a heat transfer tube, to a heat exchange device, and to a method for manufacturing the metal tube.

Background Art

It has been proposed to additionally use, in a heat exchanger for air conditioning equipment, a cooling method that utilizes the heat of vaporization of liquid in order to improve cooling efficiency and simultaneously to reduce power consumption.

For example, Japanese Unexamined Patent Application Publication No. 2003-083639 (PTL 1) describes a heat exchanger in which heat is exchanged between a plurality of vertically arranged radiator fins and a plurality of horizontally arranged coolant radiator pipes disposed so as to pass through the radiator fins and in which water is supplied from upper portions of the radiator fins to further cool the radiator fins through the heat of evaporation of the water. When air is supplied to the heat exchanger using, for example, a fan, heat is exchanged with the radiator fins, and cooled air is thereby obtained. The amount of water supplied from the upper portions of the radiator fins can be appropriately controlled. For example, by allowing water droplets to fall so as to come into contact with two fins simultaneously, heat is exchanged with both the two fins, and high cooling efficiency can thereby be obtained.

In other known air conditioning equipment, no specific coolant is used, and only the heat of evaporation of liquid is used to perform cooling and heating.

For example, Japanese Unexamined Patent Application Publication No. 2013-200059 (PTL 2) describes an air-conditioning ventilation system including indirect evaporative cooling means for exchanging sensible heat between a cooling passage through which outside air taken from the outdoors flows and an evaporation passage through which indoor air taken from a room flows and which is cooled through the heat of evaporation of a volatile liquid supplied to the evaporation passage.

Citation List

Patent Literature

PTL 1: Japanese Unexamined Patent Application Publication No. 2003-083639
PTL 2: Japanese Unexamined Patent Application Publication No. 2013-200059

Summary of Invention

Technical Problem

The cooling method described in PTL 1 has a problem in that since the discharged cooled air contains a large amount of water, such humid air does not provide a comfortable cool feeling. The air-conditioning ventilation system using the indirect evaporative cooling means as described in PTL 2 has a problem in that the efficiency of utilization of the latent heat of the liquid such as water is low.

In view of the above problems, it is an object to provide a metal tube excellent in heat exchange efficiency and to provide a metal tube for heat exchange that can utilize the latent heat of liquid with high efficiency and contributes to a reduction in size of a heat exchange device.

Solution to Problem

A metal tube according to one embodiment of the present invention employs the following configuration in order to achieve the above object.

(1) A metal tube according to one embodiment of the present invention is a metal tube including a metal substrate and a metal porous body disposed on at least part of a surface of the metal substrate, the metal tube being obtained by the steps of: joining the metal porous body to the at least part of the surface of the metal substrate in flat plate form; and forming the metal substrate with the metal porous body joined thereto into a tubular shape.

Advantageous Effects of Invention

With the above-described configuration, a metal tube excellent in heat exchange efficiency can be provided, and a metal tube for heat exchange that can utilize the latent heat of liquid with high efficiency and contributes to a reduction in size of a heat exchange device can also be provided.

Brief Description of Drawings

[Fig. 1] Figure 1 is a schematic diagram showing an example of the structure of the metal tube of the present invention.
[Fig. 2] Figure 2 is an enlarged schematic diagram of a cross section of another example of the structure of the metal tube of the present invention.
[Fig. 3] Figure 3 is a schematic diagram showing a transverse cross section of an example of the heat exchange device of the present invention.
[Fig. 4] Figure 4 is a schematic diagram showing a longitudinal cross section of an example of the heat exchange device of the present invention.
[Fig. 5] Figure 5 is a schematic diagram showing an example of a metal joined body obtained by joining a metal porous body to a metal substrate.
[Fig. 6] Figure 6 is a schematic diagram showing another example of a metal joined body obtained by joining metal porous bodies to a metal substrate.
[Fig. 7] Figure 7 is a photograph of a surface of a skeleton in an example of a metal porous body, the surface being observed under an electron microscope. Description of Embodiments

First, the details of embodiments of the present invention will be itemized and described.

(1) A metal tube according to an embodiment of the present invention is a metal tube including a metal substrate and a metal porous body disposed on at least part of a surface of the metal substrate, wherein the metal tube is obtained by the steps of: joining the metal porous body to the at least part of the surface of the metal substrate in flat plate form and forming the metal substrate with the metal porous body joined thereto into a tubular shape.
In the metal tube according to (1), since the metal porous body is disposed on at least part of the surface of the metal substrate, the surface area of the metal tube is much larger than the surface area of a conventional metal tube including only a metal substrate.
Therefore, the metal porous body allows the area of contact with liquid to increase, so that the efficiency of utilization of the latent heat of the liquid can be increased. When the metal tube is used for a heat exchange device, this high efficiency of utilization of the latent heat allows a reduction in size of the device.
The metal tube according to the embodiment of the present invention can be used not only for a heat exchange device but also for other applications.
(2) A metal tube according to an embodiment of the present invention is the metal tube according to (1) above, wherein the metal porous body is disposed on at least an inner surface of the metal tube.
The metal porous body may be disposed on the inner surface of the metal tube, its outer surface, or both the inner and outer surfaces. Preferably, the metal porous body is disposed on at least the inner surface. In this case, the metal tube can be preferably used as a heat transfer tube of a heat exchange device in which a heating medium is supplied to the inner surface of the metal tube.
(3) A metal tube according to an embodiment of the present invention is the metal tube according to (1) or (2) above, wherein a material of the metal substrate is aluminum or copper.
(4) A metal tube according to an embodiment of the present invention is the metal tube according to any one of (1) to (3) above, wherein a material of the metal porous body is aluminum or copper.
Aluminum and copper are metals excellent in thermal conductivity. Therefore, preferably, the material of the metal substrate is any of these metals because heat can be efficiently exchanged between the inner and outer sides of the metal tube. Similarly, preferably, the material of the metal porous body is aluminum or copper because heat can be efficiently exchanged between the inner and outer sides of the metal tube.
(5) A metal tube according to an embodiment of the present invention is the metal tube according to any one of (1) to (4) above, wherein the metal substrate and the metal porous body are made of the same material.
Generally, when different metal materials are joined together, corrosion may progress from the joint portion. The use of the same metal material for the metal substrate and the metal porous body is preferable because the above problem can be solved.
(6) A metal tube according to an embodiment of the present invention is the metal tube according to any one of (1) to (5) above, wherein the metal porous body has a three-dimensional network structure.

(7) A metal tube according to an embodiment of the present invention is the metal tube according to any one of (1) to (6) above, wherein irregularities are formed on a surface of a skeleton of the metal porous body.

(8) A metal tube according to an embodiment of the present invention is the metal tube according to any one of (1) to (7) above, wherein through holes are formed in a skeleton of the metal porous body.

The metal porous body having a three-dimensional network structure has a very large surface area and can therefore further increase the efficiency of utilization of the latent heat of the liquid. In addition, the porosity of this metal porous body is also very high. This is preferable because the circulation of the liquid is hardly inhibited.

When the irregularities are formed on the surface of the skeleton of the metal porous body, the surface area of the metal porous body is further increased, and this is preferable because the efficiency of utilization of the latent heat of the liquid can be further improved. Similarly, it is preferable to form through holes in the skeleton of the metal porous body, because the efficiency of utilization of the latent heat of the liquid can be further improved.

(9) A metal tube according to an embodiment of the present invention is the metal tube according to any one of (1) to (8) above, wherein the metal tube is a rectangular tube having a rectangular cross section.

No particular limitation is imposed on the shape of the metal tube. The metal tube may be a cylindrical tube having a circular or elliptical transverse cross section or may be a flat tube having a rectangular transverse cross section. Particularly, the rectangular cross section is preferred because, when a plurality of metal tubes are arranged and used, they can be disposed such that the overall efficiency of utilization is high.

(10) A heat transfer tube according to an embodiment of the present invention is a heat transfer tube including the metal tube according to any one of (1) to (9) above.

The metal tube is preferably a heat transfer tube for exchanging heat between its inner surface side and outer surface side, because the metal tube can be used for a heat exchange device.

(11) A heat exchange device according to an embodiment of the present invention is a heat exchange device including: a liquid supply unit for supplying a liquid to the metal porous body of the heat transfer tube according to (10) above; a gas supply unit for causing a gas to flow along a surface of the metal porous body; and a fluid supply unit for causing a fluid to flow along a surface of the metal substrate that is opposite to the metal porous body.

In the heat exchange device according to (11) above, the metal tube including the metal porous body portion with a very large surface area is used as the heat transfer tube. Therefore, in the heat exchange device, the efficiency of utilization of the latent heat of the liquid is very high. This heat exchange device can be smaller in size than a heat exchange device that uses a conventional heat transfer tube.

(A) A heat exchange device according to an embodiment of the present invention is the heat exchange device according to (11) above, wherein the metal porous body is disposed on an inner surface of the heat transfer tube.

The metal porous body may be disposed on the inner surface of the heat transfer tube, its outer surface, or both the inner and outer surfaces. Preferably, the metal porous body is disposed on at least the inner surface. In this case, a heat exchange device in which a heating medium is supplied to the inner surface of the heat transfer tube can be preferably provided.

(12) A heat exchange device according to an embodiment of the present invention is the heat exchange device according to (11) or (A) above, wherein the fluid is a gas.

In this heat exchange device according to the embodiment of the present invention, any fluid can be cooled so long as it can flow through the device. When the fluid is a gas, the heat exchange device can be used as, for example, a heat exchange device for air conditioning equipment. In this case, the outside air taken from the outside can be cooled, and the cooled air can be delivered to a room.

(13) A method for manufacturing a metal tube according to an embodiment of the present invention is a metal tube manufacturing method including the steps of: joining a metal porous body to at least part of a surface of a metal substrate in flat plate form to obtain a metal joined body; and bending the metal joined body into a tubular shape.

(14) A method for manufacturing a metal tube according to an embodiment of the present invention is the metal tube manufacturing method according to (13) above, wherein the metal porous body is not disposed on a fold portion of the metal joined body.

(15) A method for manufacturing a metal tube according to an embodiment of the present invention is a metal tube manufacturing method including the steps of: preparing a plurality of metal joined bodies each including a metal substrate in flat plate form and a metal porous body joined to at least part of a surface of the metal substrate; and joining end portions of the plurality of metal joined bodies to one another to form the metal joined bodies into a tubular shape.

(16) A method for manufacturing a metal tube according to an embodiment of the present invention is the metal tube manufacturing method according to (15) above, wherein the metal porous body is not disposed on each of the joined end portions of the metal joined bodies.

With the metal tube manufacturing method according to (13) or (15) above, the metal tube according to any of the embodiments of the present invention can be manufactured easily and efficiently. With the metal tube manufacturing method according to (14) or (16) above, crushing of the skeleton of the metal porous body that is caused by bending of the metal porous body in the manufacturing process of the metal tube can be suppressed.

[Details of the embodiments of the present invention]

Specific examples of the metal tubes etc. according to the embodiments of the present invention will next be described. However, the present invention is not limited to these examples and is defined by the scope of the claims. It is intended that the present invention includes all modifications which fall within the scope of the claims and equivalents thereof.

<Metal tube>

A metal tube according to an embodiment of the present invention is a metal tube including a metal substrate and a metal porous body disposed on at least part of the surface of the metal substrate and is obtained by the steps of: joining the metal porous body to the at least part of the surface of the metal substrate in flat plate form; and forming the metal substrate with the metal porous body joined thereto into a tubular shape.

As described above, the metal tube allows high efficiency of utilization of the latent heat of liquid and can contribute to a reduction in size of a heat exchange device.

The metal tube is obtained by the steps of: joining the metal porous body to the at least part of the surface of the metal substrate in flat plate form; and forming the metal substrate with the metal porous body joined thereto into a tubular shape. The above-described metal tube may be manufactured using, for example, a method including joining a metal porous body formed into a tubular shape to the inner or outer surface of a metal substrate formed into a tubular shape. However, with this method, when a low-strength metal material such as aluminum is used, the metal porous body cannot be formed into a tubular shape, so that the metal tube cannot be manufactured.

However, the use of the above-described method including joining the metal porous body to the surface of the metal substrate and then forming the resultant metal substrate into a tubular shape allows the metal tube to be obtained even when a low-strength metal material such as aluminum is used.

No particular limitation is imposed on the method of joining the metal porous body to the metal substrate, and brazing, diffusion joining, etc. can be used. In this case, it is desirable to firmly join the metal porous body to the metal substrate so that the thermal resistance between the inner and outer sides of the metal tube is small.

In the metal tube, the metal porous body may be disposed on the inner surface of the metal tube, its outer surface, or both the surfaces. Preferably, the metal porous body is disposed on at least the inner surface. This allows the metal tube to be preferably used as a heat transfer tube of a heat exchange device in which a heating medium is supplied to the inner surface of the metal tube.

No particular limitation is imposed on the material of the metal substrate. For example, aluminum (Al), copper (Cu), nickel (Ni), iron (Fe), etc. or an alloy thereof can be used for the metal substrate. When the metal tube is used for a heat exchange device, it is preferable to use a high-thermal conductivity metal for the metal substrate. From this point of view, among the above materials, aluminum or copper is preferably used for the metal substrate. With attention given only to the thermal conductivity, it is preferable to use copper for the metal substrate. In consideration of workability for manufacturing the metal tube, weight, availability of the material (whether or not it is a rare resource), etc., it is preferable to use aluminum for the metal substrate.

No particular limitation is imposed on the material of the metal porous body, and aluminum (Al), copper (Cu), nickel (Ni), iron (Fe), etc., or an alloy thereof can be used, as for the material of the metal substrate. When the metal tube is used for a heat exchange device, it is preferable to use a high-thermal conductivity metal for the metal porous body, and it is, therefore, preferable to use aluminum or copper for the metal porous body. With attention given only to the thermal conductivity, it is preferable to use copper for the metal porous body, as for the metal substrate. In consideration of workability for manufacturing the metal tube, weight, availability of the material (whether or not it is a rare resource), etc., it is preferable to use aluminum for the metal porous body.

Preferably, the metal substrate and the metal porous body are made of the same material. In this case, a problem of corrosion that can occur when different materials are joined together can be avoided. Therefore, preferably, the metal tube described above is a metal tube composed of a metal substrate and a metal porous body that are made substantially of aluminum or a metal tube composed of a metal substrate and a metal porous body that are made substantially of copper. The phrases "made substantially of aluminum" and "made substantially of copper" mean that components other than aluminum and copper may be unavoidably contained.

The metal porous body may be any metal porous body having many communicating pores and therefore having a large-surface area structure. Particularly, the metal porous body is preferably a metal porous body having a three-dimensional network structure.

The metal porous body having a three-dimensional network structure may be produced by any method such as a plating method, a sintering method, or a casting method. From the viewpoint of controlling the pore diameter and thickness of the metal porous body, it is preferable to produce the metal porous body by a plating method. When the metal porous body having a three-dimensional network structure is produced using the plating method, a resin molded body having the three-dimensional network structure may be used as a substrate. The resin molded body may be any resin molded body having continuous pores (communicating pores), and a foamed resin molded body or a resin molded body having a form like a nonwoven fabric composed of entangled resin fibers can be used. When a resin molded body in nonwoven fabric form is used as the substrate, a metal porous body having a nonwoven fabric-like three-dimensional network structure can be obtained.

Preferably, irregularities are formed on the surface of the skeleton of the metal porous body. This allows the surface area of the metal porous body to further increase, so that the efficiency of utilization of the latent heat of liquid can be improved.

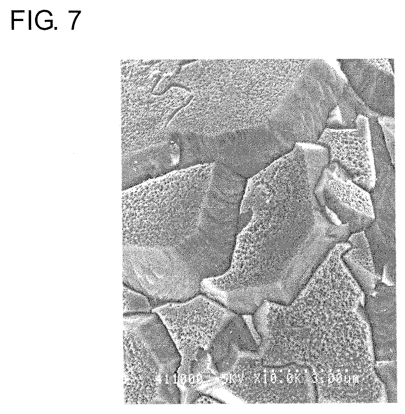

When the metal porous body is produced by a plating method, the concentration of a leveling agent added to a plating solution is controlled to roughen the surface of a plating film formed on the surface of the skeleton, and the irregularities can thereby be formed. Alternatively, fine irregularities can be formed in the metal structure of the surface of the skeleton as shown in Figure 7 by appropriately selecting the conditions of production, as described later. Figure 7 is a photograph of the surface of the skeleton in an example of the metal porous body observed under an electron microscope.

When the metal porous body is produced by a plating method, fine spherical bodies made of a resin may be added to a plating solution as described in Japanese Unexamined Patent Application Publication No. 2012-041608. In this case, fine pores having a diameter smaller than the pore diameter of the metal porous body can be formed on the surface of the skeleton of the metal porous body, and the metal porous body produced has irregularities formed on the surface of the skeleton.

In any of the above cases, the irregularities formed on the surface of the skeleton are preferable because the surface area of the metal porous body can be increased.

Preferably, the metal porous body has through holes formed in its skeleton. Particularly, the metal porous body obtained by a plating method and having a three-dimensional network structure has a hollow skeleton. Therefore, the through holes formed on the surface of the skeleton are preferable because the space inside the skeleton can also be utilized. To form the through holes in the skeleton of the metal porous body, the metal porous body may be produced, for example, as follows. First, the surface of the resin molded body used as the substrate is subjected to electrical conduction treatment by non-electrolytic plating. In this case, a short plating time is used or the concentration of a catalyst is reduced to thereby form defects. In the subsequent plating step, no plating is formed on the defect portions, so that through holes can be formed.

No particular limitation is imposed on the shape of the metal tube. The metal tube may be a cylindrical tube having a circular or elliptical transverse cross section or a rectangular tube having a rectangular transverse cross section. Particularly, rectangular tubes are preferred because, for example, when a plurality of metal tubes arranged in a heat exchange device are used, these metal tubes can be disposed such that the overall efficiency of utilization is high.

No particular limitation is imposed on the thickness of the metal substrate, and the thickness may be appropriately changed according to the size etc. of the metal tube to be manufactured.

Preferably, the metal porous body has a pore diameter of about 1 $\mu$m or more and about 3,500 $\mu$m or less. In this case, when a liquid is supplied to the metal porous body portion of the metal tube, the liquid can be preferably held in the porous portion.

Preferably, the metal porous body has a thickness of about 1 mm or more and about 3 mm or less. In this case, the liquid can be supplied to the metal porous body using, for example, simple means such as dropwise addition of the liquid.

(Method for producing metal porous body)

As an example of the method for producing the metal porous body, a method for producing an aluminum porous body having a three-dimensional network structure will next be described.

The aluminum porous body can be produced by a plating method using a molten salt bath. Specifically, a resin molded body, such as foamed urethane, having a three-dimensional network structure including communicating pores (this resin molded body may be hereinafter referred to simply as a "resin molded body") is used as a core material. After the resin molded body is subjected to electrical conduction treatment, electrolytic plating with aluminum is performed in the molten salt bath. Then the resin structure with an aluminum film formed thereon is subjected to heat treatment to burn off the resin, whereby an aluminum porous body with only the metal layer remaining can be obtained.

- Preparation of resin molded body having three-dimensional network structure -

First, a resin molded body having a three-dimensional network structure and having communicating pores is prepared. Any resin can be selected as the material of the resin molded body. Examples of the material include foamed resin molded bodies formed of polyurethane, melamine, polypropylene, polyethylene, etc.

Foamed urethane and foamed melamine have high porosity, allow communication between their pores, have good thermal decomposition properties, and can therefore be preferably used for the foamed resin molded body. Foamed urethane is preferred from the viewpoint of uniformity of the pores, availability, etc. and also from the viewpoint that a small pore size can be obtained.

The resin molded body often contains residues such as a foaming agent and an unreacted monomer that are used in the process of producing the foam, and it is therefore preferable, for the sake of the subsequent steps, to perform washing treatment. The resin molded body forms a three-dimensional network serving as its skeleton, and the three-dimensional network as a whole forms continuous pores. The skeleton of the foamed urethane has a substantially triangular shape in a cross section perpendicular to the extending direction of the skeleton.

Preferably, the foamed resin molded body has a porosity of 80% to 98% and a pore diameter of 1 $\mu$m to 3,500 $\mu$m. The pore diameter of the foamed resin molded body is its cell diameter.

The porosity is defined by the following formula:

$$\text{Porosity} = (1 - (\text{weight [g] of porous material} / (\text{volume [cm}^3\text{] of porous material} \times$$

$$\text{density of raw material}))) \times 100 \; [\%]$$

The pore diameter is determined using, for example, an enlarged photograph of the surface of the resin molded body taken under a microscope. Specifically, the number of pores per inch (25.4 mm) is counted as the number of cells, and then an average value, i.e., an average pore diameter = 25.4 mm/the number of cells, is determined.

- Imparting electrical conductivity to surface of resin molded body -

The surface of the resin molded body is subjected to electrical conduction treatment in advance, in order to subject the surface of resin molded body to electrolytic plating with aluminum. No particular limitation is imposed on the electrical conduction treatment, so long as an electrically conductive layer can be disposed on the surface of the resin molded body. Any method such as non-electrolytic plating with an electrically conductive metal such as nickel, vapor deposition or sputtering of aluminum etc., or application of an electrically conductive coating containing electrically conducive particles such as carbon particles can be selected.

Examples of the electrical conduction treatment, i.e., an electrical conduction treatment method using aluminum sputtering treatment and a method including subjecting the surface of the resin molded body to electrical conduction treatment using carbon particles as electrically conducive particles, will be described below.

-- Aluminum sputtering --

The sputtering treatment using aluminum is not limited so long as aluminum is used as a target and may be performed according to a routine procedure. For example, the resin molded body is attached to a substrate holder, and then a direct-current voltage is applied between the holder and the target (aluminum) while an inert gas is introduced. This causes the ionized inert gas to collide with aluminum, and sputtered aluminum particles are deposited on the surface of the resin molded body to form a sputtering film of aluminum. Preferably, the sputtering treatment is performed at a temperature at which the resin molded body does not melt, specifically at about 100 to about 200°C and preferably about 120 to about 180°C.

-- Application of carbon --

First, a carbon coating used as an electrically conductive coating is prepared. Preferably, a suspension containing carbon particles, a binder, a dispersant, and a dispersion medium is used as the electrically conductive coating. To apply the electrically conductive particles uniformly, it is necessary that the suspension maintain its uniformly suspended state. It is therefore preferable that the suspension is maintained at 20°C to 40°C. When the temperature of the suspension is 20°C or higher, the uniformly suspended state can be maintained, and a good carbon particle layer can be formed on the surface of the skeleton of the network structure of the resin porous body. When the temperature of the suspension is 40°C or lower, an increase in the amount of dispersant evaporated is restrained, so that thickening of the suspension can be prevented.

The carbon particles have a particle diameter of preferably 0.01 to 5 $\mu$m and more preferably 0.01 to 2 $\mu$m. A large particle diameter may cause cells of the resin molded body to be clogged or the formation of smooth plating to be inhibited. When the particle diameter is excessively small, it is difficult to ensure sufficient electrical conductivity.

The carbon particles can be applied to the resin molded body by immersing the resin molded body in the suspension, followed by squeezing and drying.

- Formation of aluminum film on surface of resin molded body -

To form an aluminum film on the surface of the resin molded body, a plating method using a molten salt bath is used.

-- Molten salt plating --

Electrolytic plating is performed in a molten salt to form an aluminum film on the surface of the resin molded body.

The aluminum plating performed in the molten salt bath allows a thick aluminum film to be formed uniformly on the surface of a complicated skeleton structure such as particularly the resin molded body having a three-dimensional network structure. A direct current is applied, in the molten salt, between the aluminum serving as an anode and the resin molded body having a surface to which electrical conductivity has been imparted and serving as a cathode.

The molten salt used may be an organic molten salt which is a eutectic salt of an organic-based halide and an aluminum halide or an inorganic molten salt which is a eutectic salt of an alkali metal halide and an aluminum halide. When an organic molten salt bath that melts at a relatively low temperature is used, the electrolytic plating can be performed without decomposition of the resin molded body used as the substrate. The organic-based halide used can be an imidazolium salt, a pyridinium salt, etc. Specifically, 1-ethyl-3-methylimidazolium chloride (EMIC) and butylpyridinium chloride (BPC) are preferable.

If moisture or oxygen is mixed into the molten salt, the molten salt degrades. Therefore, it is preferable to perform the plating in an inert gas atmosphere such as a nitrogen or argon atmosphere and in a closed environment.

The molten salt bath is preferably a molten salt bath containing nitrogen, and an imidazolium salt bath is particularly preferably used. When the molten salt used is a salt that melts at a high temperature, the rate of dissolution or decomposition of the resin in the molten salt is higher than the rate of the growth of a plating film, so that the plating film cannot be formed on the surface of the resin molded body. The imidazolium salt bath can be used even at a relatively low temperature with no influence on the resin. The imidazolium salt used is preferably a salt containing an imidazolium cation having alkyl groups at the 1- and 3-positions. Particularly, an aluminum chloride-1-ethyl-3-methylimidazolium chloride (AlCl$_3$-EMIC)-based molten salt is most preferably used because it is highly stable and resists decomposition. Such a molten salt can be used for plating of foamed urethane resins and foamed melamine resins, and the temperature of the molten salt bath is 10°C to 100°C and preferably 25°C to 45°C. As the temperature of the molten salt bath decreases, the range of current density that enables plating becomes narrow, and this causes a difficulty in plating the entire surface of the resin molded body.

As a result of the above steps, an aluminum-resin structure including the resin molded body serving as the core of the skeleton is obtained.

- Removal of resin -

The resin structure obtained as described above is subjected to heat treatment. Specifically, the resin structure is heated, for example, in a nitrogen atmosphere or in air at 500°C or higher to burn off the resin, whereby an aluminum porous body is obtained.

It has been found that, in order to produce an aluminum porous body in which the surface of its skeleton is rough and has irregularities, it is effective to improve the step conventionally performed. Specifically, the following methods can be used.

-- Treatment of plating solution adhering to resin structure --

Immediately after the production of the resin molded body having the aluminum film on its surface as described above, the aluminum plating solution is adhering to the surface of the resin molded body. Therefore, rinsing treatment is performed, and then heat treatment is performed.

In this case, the rinsing treatment is performed with the plating solution not sufficiently drained. This allows an aluminum porous body having fine irregularities formed on the surface of its skeleton to be obtained. This may be because the plating solution containing the molten salt described above reacts with water to generate heat and aluminum reacts with water on the surface of the aluminum film to form boehmite. Generally, boehmite undergoes a dehydration reaction at 450°C or higher and transforms into γ-alumina having micropores. Also in the process for producing the aluminum porous body, the resin molded body is exposed to a high temperature of 500°C or higher during removal of the resin from the resin structure by burning. Therefore, the boehmite formed as described above transforms into γ-alumina, and fine irregularities are thereby formed on the surface of the skeleton.

To obtain an aluminum porous body having fine irregularities formed on the surface of its skeleton using the above-described method, it is preferable to perform the rinsing treatment in a state in which the amount of the plating solution adhering to the resin structure is 20 mL/m$^2$ to 2,000 mL/m$^2$. The amount of the adhering plating solution is more preferably 200 mL/m$^2$ to 2,000 mL/m$^2$ and still more preferably 1,000 mL/m$^2$ to 2,000 mL/m$^2$.

-- Rinsing treatment for resin structure --

Even when the plating solution has been sufficiently removed in the treatment of the plating solution adhering to the resin structure described above, an aluminum porous body having fine irregularities formed on the surface of its skeleton can be produced as follows. Specifically, the rinsing treatment is performed in order to remove the plating solution adhering to the resin molded body having the aluminum film on its surface, as described above. After that, water adhering to the resin structure is not removed sufficiently, and then heat treatment for removing the resin is performed. In this case, the following may occur. Aluminum reacts with the water on the surface of the aluminum film at about 80°C during the step of heating the resin structure, and boehmite is thereby formed. Then the boehmite is further heated and thereby transforms into γ-alumina having micropores.

To obtain an aluminum porous body having fine irregularities formed on the surface of its skeleton using the above-described method, it is preferable to perform the treatment for removing the resin by burning in a state in which the amount of water adhering to the resin structure is 10 mL/m$^2$ to 1,000 mL/m$^2$. The amount of adhering water is more preferably 100 mL/m$^2$ to 1,000 mL/m$^2$ and still more preferably 500 mL/m$^2$ to 1,000 mL/m$^2$.

-- Removal of resin from resin structure by burning --

An aluminum porous body having fine irregularities formed on the surface of its skeleton can also be produced using a method other than the above-described two methods. Specifically, even when the plating solution has been drained sufficiently and also the water adhering in the subsequent rinsing treatment has been removed sufficiently, the above aluminum porous body may be produced by performing the subsequent step of removing the resin by burning in a high-dew point atmosphere containing a large amount of water. To achieve this, for example, heat treatment is performed by heating to 500°C or higher while humidified air is supplied. Also in this case, the following may occur. Aluminum reacts at about 80°C with the water supplied to the atmosphere for the heat treatment, and boehmite is thereby formed. Then the boehmite is further heated and thereby transforms into γ-alumina having micropores.

To obtain an aluminum porous body having fine irregularities formed on the surface of its skeleton using the above-described method, the dew-point temperature of the atmosphere in the step of removing the resin by burning is preferably 0°C to 60°C. The dew-point temperature is more preferably 20°C to 60°C and still more preferably 40°C to 60°C.

<Heat transfer tube>

A heat transfer tube according to an embodiment of the present invention includes the metal tube according to the above-described embodiment of the present invention.

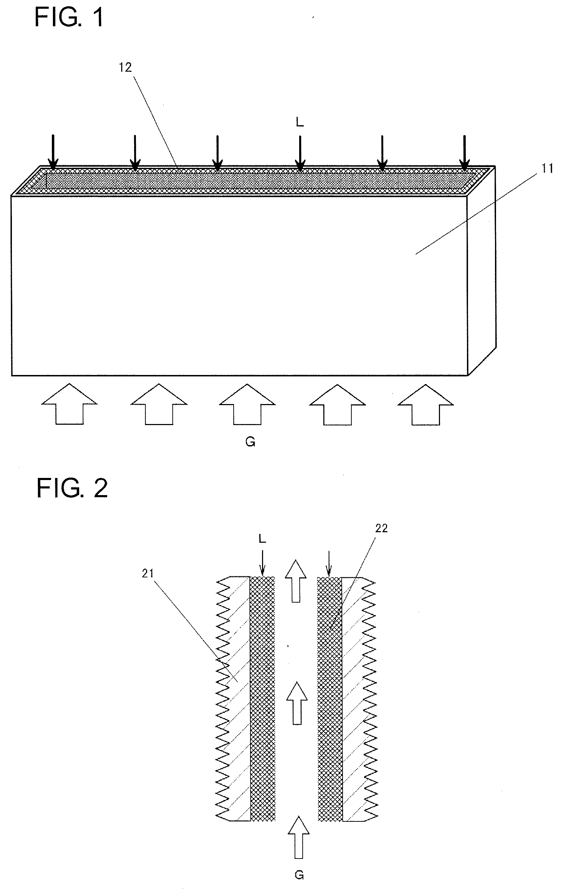

Referring to Figure 1, a description will be given of an example of a method for using, as a heat transfer tube, a metal tube which has a rectangular transverse cross section and in which a metal porous body 12 is disposed on the inner surface side of a tubular metal substrate 11.

In the example shown in Figure 1, the heat transfer tube is used with its openings directed in a vertical direction. A liquid L is supplied to the metal porous body 12 from an upper portion of the heat transfer tube. In Figure 1, the liquid L is illustrated so as to be supplied to one side surface of the heat transfer tube. In practice, the liquid L may be supplied to all the four surfaces.

The liquid L supplied to the metal porous body 12 flows along the surface of the skeleton of the metal porous body 12 by gravity toward a lower portion of the heat transfer tube. In the course of this process, the liquid L evaporates, so that the heat of the surface of the skeleton of the metal porous body 12 is removed as the heat of evaporation. The metal porous body 12 is thereby cooled, and the metal substrate 11 joined to and thermally connected to the metal porous body 12 is also cooled. Figure 2 is a partial enlarged view of a longitudinal cross section of the metal tube in Figure 1.

As the liquid L continuously evaporates, the vapor pressure inside the metal tube increases, so that the liquid L becomes less likely to evaporate. Therefore, a gas G is supplied to metal porous bodies 12 and 22. This allows the liquid L to be more likely to evaporate. When the gas G used is reduced in moisture content, the evaporation of the liquid L can be facilitated, and its ability to cool can be improved.

From the viewpoint of supplying the liquid L to the metal porous bodies 12 and 22 as described above, it is preferable that the wettability of the metal porous bodies 12 and 22 to the liquid L is high. Therefore, preferably, the surfaces of the metal porous bodies 12 and 22 are processed as needed. When an aluminum porous body having a three-dimensional network structure is used while water is supplied thereto, although aluminum has a relatively high affinity for water, gas in the aluminum porous body may prevent water from entering its porous portion. In this case, for example, it is preferable to supply water vapor to the aluminum porous body portion before use of the heat transfer tube to sufficiently wet the surface of the aluminum porous body. Alternatively, the aluminum porous body may be such that a material having a high affinity for water and a high thermal conductivity is supported on its surface.

As shown in Figure 2, it is preferable that a surface (outer surface) of a metal substrate 21 that is opposite to the metal porous body 22 is, for example, subjected to processing and formed into a rough surface. By roughening the outer surface of the metal substrate 21 to increase its surface area as described above, the efficiency of heat transfer when, for example, a fluid is supplied to the outer surface of the metal substrate 21 to transfer the heat of the metal substrate 21 to the fluid can be increased. Besides the above-described processing, a member having a larger surface area such as a metal porous body may be joined to the outer surface of the metal substrate 21. Particularly, a metal porous body having a three-dimensional network structure not only has a large surface area but also has an extremely large porosity. Such a metal porous body is preferable because the flow of the fluid is not impeded.

No particular limitation is imposed on the liquid L, and the liquid L used may be a highly volatile liquid such as water or an organic solvent. No particular limitation is imposed on the gas G, and the gas G used may be an easy-to-supply gas such as atmospheric air.

For example, when water is supplied to the metal porous body of the heat transfer tube and air at 35°C and a humidity of about 45% is sent to the metal tube, cooled but humid air at 27°C and a humidity of about 90% is discharged. The outer surface of the metal tube is cooled to about 27°C. Therefore, when air at 35°C and a humidity of about 45% is supplied to the outer surface of the metal tube, cooled and relatively dry air at 27°C and a humidity of about 65% is obtained.

<Heat exchange device>

A heat exchange device according to an embodiment of the present invention includes: a liquid supply unit for supplying a liquid to the metal porous body of the heat transfer tube; a gas supply unit for causing a gas to flow along the surface of the metal porous body; and a fluid supply unit for causing a fluid to flow along a surface of the metal substrate that is opposite to the metal porous body.

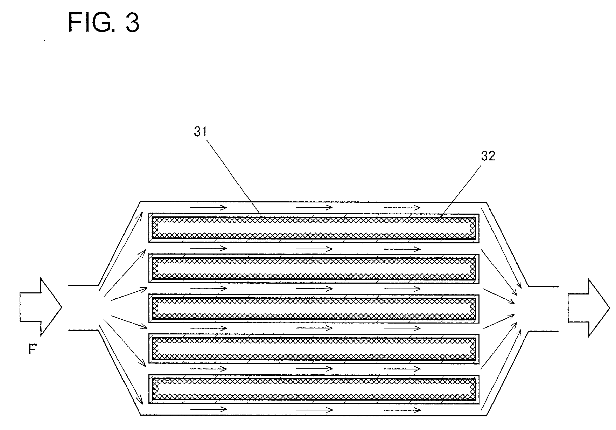

Figure 3 is a transverse cross-sectional view of an example of the heat exchange device according to the embodiment of the present invention. In Figure 3, a plurality of metal tubes shown in Figure 1 are arranged and used as heat transfer tubes. As in the case of the metal tube in Figure 1, a liquid is supplied to a metal porous body 32 of each of the metal tubes in Figure 3 from the upper surface side of the drawing sheet, and a gas is supplied to the metal porous body 32 from the undersurface side of the drawing sheet. The liquid evaporates from the surfaces of the metal porous bodies 32, and the metal porous bodies 32 are thereby cooled, so that metal substrates 31 thermally connected to the metal porous bodies 32 are also cooled.

In the heat exchange device shown in Figure 3, the fluid F is supplied to surfaces (outer surfaces) of the metal substrates 31 that are opposite to the metal porous bodies 32. In this case, heat is exchanged between the fluid F and the outer surfaces of the cooled metal substrates 31, and the fluid F is thereby cooled and discharged from the heat exchange device.

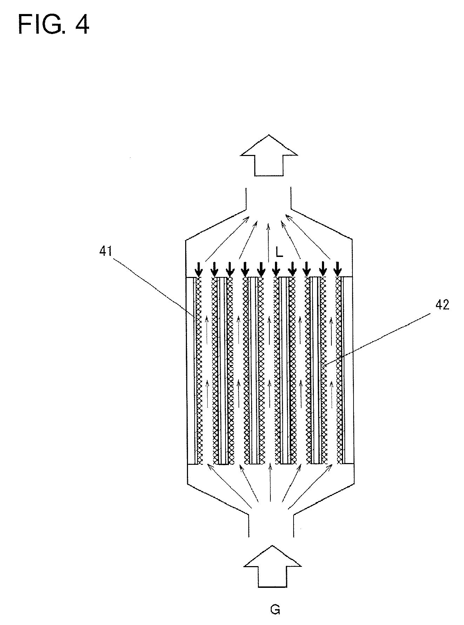

Figure 4 is a longitudinal cross-sectional view of an example of a heat exchange device according to an embodiment of the present invention. A liquid L is supplied to metal porous bodies 42 of metal tubes from an upper portion of the heat exchange device, and a gas G is supplied to the metal porous bodies 42 from a lower portion of the heat exchange device. The liquid L evaporates from the surfaces of the metal porous bodies 42, and the metal porous bodies 42 are thereby cooled, so that metal substrates 41 thermally connected to the metal porous bodies 42 are also cooled. A fluid is supplied to the outer surfaces of the metal substrates 41 from the upper surface side of the drawing sheet. Heat is thereby exchanged between the fluid and the metal substrates 41, and the cooled fluid is discharged.

In each of the heat exchange devices according to the embodiments of the present invention, the metal porous bodies may be disposed on the inner surfaces of the heat transfer tubes, their outer surfaces, or both the inner and outer surfaces. It is preferable that the metal porous bodies are disposed on at least the inner surfaces. In this case, a heat exchange device in which a heating medium is supplied to the inner surfaces of the heat transfer tubes can be preferably provided.

No particular limitation is imposed on the fluid, so long as it can flow along the surfaces of the metal substrates.

The fluid can be a gas or a liquid. For example, by supplying outside air from the outside of a room, cooled air can be supplied to the room.

<Methods for manufacturing metal tube>

(Embodiment 1)

A method for manufacturing a metal tube according to an embodiment of the present invention is a metal tube manufacturing method including the steps of: joining a metal porous body to at least part of a surface of a metal substrate in flat plate form to form a metal joined body; and bending the metal joined body into a tubular shape.

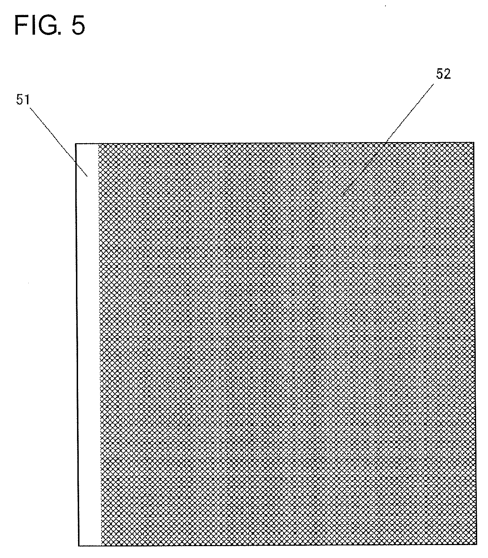

Figure 5 is a schematic diagram of an example of a metal joined body prepared by joining a metal porous body to at least part of a surface of a metal substrate 51 in flat plate form. In the example shown in Figure 5, a portion with no metal porous body 52 joined thereto is provided in the left edge of the metal substrate 51. When the metal joined body is bent into a tubular shape, the portion with no metal porous body 52 disposed thereon is joined to the opposite surface of the metal substrate 51. No particular limitation is imposed on the method for joining the metal porous body 52 to the metal substrate 51, and brazing, diffusion joining, etc. may be used. No particular limitation is imposed on the shape of the metal tube. The metal tube may be a cylindrical tube having a circular or elliptical transverse cross section or may be a flat tube having a rectangular transverse cross section.

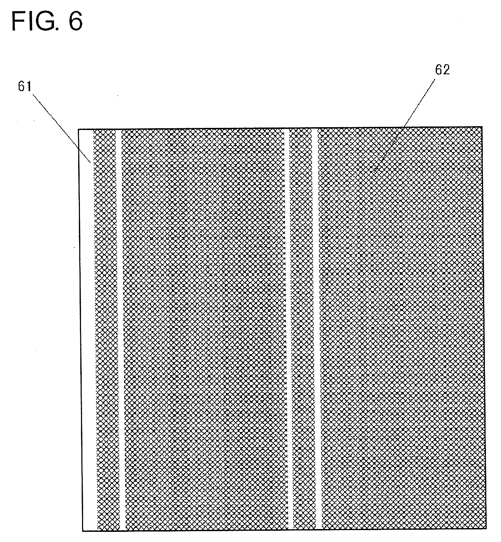

Figure 6 is a schematic diagram of another example of a metal joined body prepared by joining metal porous bodies 62 to at least part of a surface of a metal substrate 61 in flat plate form. As shown in Figure 6, no metal porous body 62 is disposed in fold portions of the metal joined body, and this allows crushing of the skeletons of the metal porous bodies 62 due to bending of the metal porous bodies 62 to be suppressed. The metal joined body shown in Figure 6 can be preferably joined into a flat metal tube having a rectangular transverse cross section.

(Embodiment 2)

A method for manufacturing a metal tube according to an embodiment of the present invention is a metal tube manufacturing method including the steps of: preparing a plurality of metal joined bodies each including a metal substrate in flat plate form and a metal porous body joined to at least part of a surface of the metal substrate; and joining end portions of the metal joined bodies to one another to form the metal joined bodies into a tubular shape. In this embodiment, it is preferable that no metal porous body is disposed on the joined end portions of the metal joined bodies.

In this embodiment, for example, two metal joined bodies shown in Figure 5 are prepared and disposed such that the metal porous bodies face each other, and their ends are joined together. It is preferable that no metal porous body is disposed on each of the joined ends of the metal joined bodies. In this case, the metal porous bodies are not crushed when the ends are joined.

Examples

The present invention will next be described in more detail by way of Examples. However, these Examples are only illustrative, and the metal tube etc. of the present invention are not limited thereto. The scope of the present invention is defined by the scope of the claims and includes all modifications which fall within the scope of the claims and equivalents thereof.

[Example 1]

(Production of metal porous body)

- Formation of electrically conductive layer -

A urethane foam having 10 cells per inch and having a porosity of 97%, a pore diameter of about 2,540 $\mu$m, and a thickness of 2 mm was prepared as a resin molded body and cut into a square shape of 200 mm x 200 mm Aluminum was deposited on the surface of the polyurethane foam to a coating weight of 10 g/m$^2$ by sputtering to form an electrically conductive layer.

- Molten salt plating -

The urethane foam with the electrically conductive layer formed on its surface was used as a workpiece and attached to a jig having a power-supply function. Then the jig was placed in a glove box with an argon atmosphere and a low moisture content (dew point: -30°C or lower) and immersed in a molten salt aluminum plating bath (prepared by adding 0.5 g/L of 1,10-phenanthroline to 33 mol% EMIC-67 mol% $AlCl_3$) at a temperature of 45°C. The jig with the workpiece attached thereto was connected to the cathode side of a rectifier, and an aluminum plate (purity: 99.99 % by mass) used as a counter electrode was connected to the anode side.

A direct current was applied at a current density of 6 A/dm$^2$ for 60 minutes for plating, and a structure in which an aluminum film with a mass of 0.2 g/cm$^3$ was formed on the surface of the urethane foam was thereby obtained. Stirring was performed with a stirrer using a rotor formed of Teflon (registered trademark). The current density is a value calculated using the apparent area of the urethane foam.

- Removal of resin -

The structure obtained above was removed from the plating bath. With the amount of the adhering plating solution being 1,500 mL/m$^2$, rinsing treatment was performed. After the rinsing treatment, the structure was sufficiently dried. With the amount of adhering water being 6 mL/m$^2$, heat treatment was performed in atmospheric air with a dew point temperature of -15°C at 600°C for 30 minutes. The resin was thereby burnt off, and an aluminum porous body (purity: 99.99% by mass) was obtained.

The surface of the skeleton of the aluminum porous body obtained was observed under an electron microscope, and it was found that fine irregularities were formed as shown in Figure 7.

(Manufacturing of metal tube)

An aluminum plate having a square shape of 1,000 mm x 1,000 mm and a thickness of 1 mm was prepared. One hundred aluminum porous bodies produced in the manner described above were prepared and processed into 100 mm x 100 mm and placed on the aluminum plate. In this case, as in the example shown in Figure 5, a portion with no aluminum porous body disposed thereon was prepared in one end portion (with an area of 1,000 mm x 40 mm) of the aluminum plate, and the aluminum porous bodies were placed on the other portion with no gap therebetween to thereby obtain an aluminum joined body. Joining was performed by brazing using a brazing material containing an aluminum alloy powder.

The aluminum joined body was deformed into a cylindrical shape, and the portion with no aluminum porous body disposed thereon was brazed to an opposite end portion of the aluminum plate that faced this portion to thereby manufacture a metal tube.

[Example 2]

The aluminum porous bodies produced in Example 1 and having a square shape of 100 mm x 100 mm were brazed to an aluminum plate having a square shape of 1,000 mm x 1,000 mm and a thickness of 1 mm to thereby obtain an aluminum joined body. In this case, as in the example shown in Figure 6, no aluminum porous body was disposed on one end portion (with an area of 1,000 mm x 40 mm) of the aluminum plate, and the aluminum porous bodies were disposed on the aluminum plate and brazed thereto with three gaps of 1,000 mm x 20 mm provided.

The above-obtained aluminum joined body was bent into a rectangular shape such that the aluminum porous bodies were located on the inner side, and the end portion with no aluminum porous body disposed thereon was brazed to an opposite end portion of the aluminum plate that faced this end portion. A metal tube having a rectangular cross section of 30 mm x 450 mm and a length of 1,000 mm was thereby obtained.

[Example 3]

Two aluminum joined bodies similar to that in Example 1 were prepared. These were disposed such that the aluminum porous bodies faced each other, and the portions with no aluminum porous body disposed thereon were brazed to end portions of the aluminum plates that faced these portions to thereby manufacture a metal tube.

Each of the metal tubes in Examples 1 to 3 includes aluminum porous bodies having a very large surface area on its inner surface and is therefore a metal tube excellent in heat exchange efficiency.

Reference Signs List

11, 21, 31, 41, 51, 61    metal substrate
12, 22, 32, 42, 52, 62    metal porous body

F               fluid
G              gas
L              liquid

## Claims

1. A metal tube comprising
   a metal substrate and
   a metal porous body disposed on at least part of a surface of the metal substrate,
   wherein the metal tube is obtained by the steps of:

   > joining the metal porous body to the at least part of the surface of the metal substrate in flat plate form; and
   > forming the metal substrate with the metal porous body joined thereto into a tubular shape.

2. The metal tube according to claim 1, wherein the metal porous body is disposed on at least an inner surface of the metal tube.

3. The metal tube according to claim 1 or 2, wherein a material of the metal substrate is aluminum or copper.

4. The metal tube according to any one of claims 1 to 3, wherein a material of the metal porous body is aluminum or copper.

5. The metal tube according to any one of claims 1 to 4, wherein the metal substrate and the metal porous body are made of the same material.

6. The metal tube according to any one of claims 1 to 5, wherein the metal porous body has a three-dimensional network structure.

7. The metal tube according to any one of claims 1 to 6, wherein irregularities are formed on a surface of a skeleton of the metal porous body.

8. The metal tube according to any one of claims 1 to 7, wherein through holes are formed in a skeleton of the metal porous body.

9. The metal tube according to any one of claims 1 to 8, wherein the metal tube is a rectangular tube.

10. A heat transfer tube comprising the metal tube according to any one of claims 1 to 9.

11. A heat exchange device comprising:

    > a liquid supply unit for supplying a liquid to the metal porous body of the heat transfer tube according to claim 10;
    > a gas supply unit for causing a gas to flow along a surface of the metal porous body; and
    > a fluid supply unit for causing a fluid to flow along a surface of the metal substrate that is opposite to the metal porous body.

12. The heat exchange device according to claim 11, wherein the fluid is a gas.

13. A method for manufacturing a metal tube, the method comprising the steps of:

    > joining a metal porous body to at least part of a surface of a metal substrate in flat plate form to obtain a metal joined body; and
    > bending the metal joined body into a tubular shape.

14. The method for manufacturing a metal tube according to claim 13, wherein the metal porous body is not disposed on a fold portion of the metal joined body.

15. A method for manufacturing a metal tube, the method comprising the steps of:

preparing a plurality of metal joined bodies each including a metal substrate in flat plate form and a metal porous body joined to at least part of a surface of the metal substrate; and
joining end portions of the plurality of metal joined bodies to one another to form the metal joined bodies into a tubular shape.

16. The method for manufacturing a metal tube according to claim 15, wherein the metal porous body is not disposed on each of the joined end portions of the metal joined bodies.

## FIG. 1

## FIG. 2

FIG. 3

# FIG. 4

# FIG. 5

FIG. 6

61

62

FIG. 7

**INTERNATIONAL SEARCH REPORT**

| International application No. |
| --- |
| PCT/JP2014/070308 |

**A. CLASSIFICATION OF SUBJECT MATTER**
*F28F1/40*(2006.01)i, *B21D53/04*(2006.01)i, *B32B1/08*(2006.01)i, *B32B5/18*
(2006.01)i, *B32B15/01*(2006.01)i, *F28D7/10*(2006.01)i, *F28D7/16*(2006.01)i,
*F28F21/08*(2006.01)i
According to International Patent Classification (IPC) or to both national classification and IPC

**B. FIELDS SEARCHED**

Minimum documentation searched (classification system followed by classification symbols)
F28F1/40, B21D53/04, B32B1/08, B32B5/18, B32B15/01, F28D7/10, F28D7/16,
F28F21/08

Documentation searched other than minimum documentation to the extent that such documents are included in the fields searched
Jitsuyo Shinan Koho        1922–1996   Jitsuyo Shinan Toroku Koho   1996–2014
Kokai Jitsuyo Shinan Koho   1971–2014   Toroku Jitsuyo Shinan Koho   1994–2014

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y | JP 7-190664 A  (Hitachi Chemical Co., Ltd.),<br>28 July 1995 (28.07.1995),<br>claims 1 to 2, 4; paragraphs [0001], [0004] to<br>[0005]; fig. 1, 4, 7<br>& US 5943543 A        & EP 744586 A1<br>& WO 1995/018350 A1     & DE 69433629 D<br>& DE 69433629 T        & CN 1138375 A<br>& KR 10-0356646 B | 1-5,7,10<br>6,8,11-12,<br>14-16 |
| X<br>Y | JP 11-217680 A  (Mitsubishi Materials Corp.),<br>10 August 1999 (10.08.1999),<br>paragraphs [0001], [0008], [0015] to [0018];<br>fig. 3, 5<br>(Family: none) | 1,3-5,7,<br>9-10,13<br>14 |

| ☒ Further documents are listed in the continuation of Box C. | ☐ See patent family annex. |

* Special categories of cited documents:
"A" document defining the general state of the art which is not considered    to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>    14 October, 2014 (14.10.14) | Date of mailing of the international search report<br>    21 October, 2014 (21.10.14) |
| --- | --- |
| Name and mailing address of the ISA/<br>    Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2014/070308 |

C (Continuation).   DOCUMENTS CONSIDERED TO BE RELEVANT

| Category* | Citation of document, with indication, where appropriate, of the relevant passages | Relevant to claim No. |
| --- | --- | --- |
| X | JP 59-104285 A  (Mitsubishi Heavy Industries, Ltd.), 16 June 1984 (16.06.1984), page 1, lower right column, line 7 to page 2, upper left column, line 4; fig. 1 to 4 (Family: none) | 1-5,7,10 |
| Y | JP 8-145592 A  (Hitachi Chemical Co., Ltd.), 07 June 1996 (07.06.1996), paragraphs [0001], [0004] to [0005] & US 5943543 A          & EP 744586 A1 & WO 1995/018350 A1      & DE 69433629 D & DE 69433629 T          & SG 33388 A & CN 1138375 A           & KR 10-0356646 B | 6,8 |
| Y | JP 2004-45022 A  (Korea Institute of Science and Technology), 12 February 2004 (12.02.2004), paragraphs [0001] to [0002], [0020], [0034] to [0035]; fig. 1, 3 & US 2004/0003619 A1     & KR 10-2004-0005108 A & CN 1486794 A           & CN 1695825 A | 11-12 |
| Y | JP 10-8586 A  (Kabushiki Kaisha OM Solar Kyokai), 13 January 1998 (13.01.1998), paragraph [0026]; fig. 2 to 3 (Family: none) | 14 |
| Y | JP 41-17514 B1  (Owens Corning Fiberglass Corp.), 05 October 1966 (05.10.1966), page 2, left column, lines 37 to 46; page 2, right column, lines 40 to 45; fig. 3, 5 (Family: none) | 14 |
| Y | JP 2009-520173 A  (Behr GmbH & Co. KG.), 21 May 2009 (21.05.2009), paragraphs [0033] to [0034]; fig. 8 & US 2008/0257530 A1     & EP 1966548 A & EP 2211126 A1          & WO 2007/073849 A2 & DE 102006058387 A | 15-16 |
| A | JP 4-110597 A  (Kobe Steel, Ltd.), 13 April 1992 (13.04.1992), page 2, upper right column, line 19 to lower left column, line 4; fig. 1 to 3 (Family: none) | 1-16 |
| A | JP 2009-85407 A  (Railway Technical Research Institute), 23 April 2009 (23.04.2009), paragraphs [0003], [0015] to [0016] (Family: none) | 6,8 |

Form PCT/ISA/210 (continuation of second sheet) (July 2009)

**INTERNATIONAL SEARCH REPORT**

International application No.

PCT/JP2014/070308

| C (Continuation). DOCUMENTS CONSIDERED TO BE RELEVANT | | |
|---|---|---|
| Category* | Citation of document, with indication, where appropriate, of the relevant passages | Relevant to claim No. |
| A | JP 61-83895 A (Hitachi, Ltd.), 28 April 1986 (28.04.1986), page 2, upper right column, lines 8 to 18; fig. 9 (Family: none) | 11-12 |
| A | US 5567504 A (SCHULLER INTERNATIONAL, INC.), 22 October 1996 (22.10.1996), fig. 6 (Family: none) | 13-14 |

Form PCT/ISA/210 (continuation of second sheet) (July 2009)

**EP 3 067 653 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003083639 A
- JP 2013200059 A
- JP 2012041608 A